(19) Europäisches Patentamt
European Patent Office
Office européen des brevets

(11) **EP 4 478 059 A1**

(12) **EUROPEAN PATENT APPLICATION**

(43) Date of publication:
**18.12.2024 Bulletin 2024/51**

(21) Application number: **24170318.0**

(22) Date of filing: **15.04.2024**

(51) International Patent Classification (IPC):
**G01R 19/00** (2006.01)    **G01D 3/036** (2006.01)
**G01R 1/20** (2006.01)

(52) Cooperative Patent Classification (CPC):
**G01R 19/0092; G01D 3/0365; G01R 1/203**

(84) Designated Contracting States:
**AL AT BE BG CH CY CZ DE DK EE ES FI FR GB GR HR HU IE IS IT LI LT LU LV MC ME MK MT NL NO PL PT RO RS SE SI SK SM TR**
Designated Extension States:
**BA**
Designated Validation States:
**GE KH MA MD TN**

(30) Priority: **16.06.2023 US 202318336240**

(71) Applicant: **Hamilton Sundstrand Corporation**
**Charlotte, NC 28217-4578 (US)**

(72) Inventors:
• LIU, Bo
  **Milford, CT (US)**
• WU, Xin
  **Glastonbury, CT (US)**
• CHANNEGOWDA, Parikshith
  **Marlborough, CT (US)**
• LEE, Yongduk
  **Manchester, CT (US)**

(74) Representative: **Dehns**
**10 Old Bailey**
**London EC4M 7NG (GB)**

(54) **HIGH-SPEED SENSING BASED ON ANALOG TWIN CIRCUIT**

(57)    An analog twin circuit device includes a sensing element (110, 210 310) and a signal conditioning circuit (120, 220 320). The sensing element (110, 210 310) includes a signal input terminal configured to receive an input signal and a signal output terminal configured to output a signal. The signal conditioning circuit (120, 220 320) includes a first circuit input terminal connected to the signal input terminal and a second circuit input terminal connected to the signal output terminal such that the sensing element (110, 210 310) interacts directly with the input signal and delivers an output signal to the signal output terminal. The signal conditioning circuit (120, 220 320) physically models the sensing element (110, 210 310).

FIG. 1

**Description**

STATEMENT OF FEDERAL SUPPORT

This invention was made with government support under 80GRC020F0166, awarded by NASA. The government has certain rights in the invention.

TECHNICAL FIELD

The devices and methods described herein relate to systems' electronic sensors, and more particularly, high-speed analog sensing.

BACKGROUND

Today's electronic systems produce and generate large amount of data and heavily rely on significant number of sensors to perform the monitoring, protection, and decision making necessary for operating the system. Fast speed sensing is particularly important in accomplishing these tasks, especially for mission critical components in a system that requires swift response and control speed such as current sensors in power converters or current and voltage protection in circuit breakers for consumer electronics, industrial motor drives, electric vehicles, and aircraft system. Moreover, the demand for such features is growing higher because the performance, reliability and risks associated with the integrated large system also scale up.

SUMMARY

According to a non-limiting embodiment, an analog twin circuit device includes a sensing element and a signal conditioning circuit. The sensing element includes a signal input terminal configured to receive an input signal and a signal output terminal configured to output a signal. The signal conditioning circuit includes a first circuit input terminal connected to the signal input terminal and a second circuit input terminal connected to the signal output terminal such that the sensing element interacts directly with the input signal and delivers an output signal to the signal output terminal, wherein the signal conditioning circuit physically models the sensing element.

According to one or more additional features, or in the alternative, the signal conditioning circuit mimics an impedance of the sensing element.

According to one or more additional features, or in the alternative, the signal conditioning circuit matches the input and output behaviours of the sensing element.

According to one or more additional features, or in the alternative, the sensing element is an inductor-resistor (LR) series circuit.

According to one or more additional features, or in the alternative, the signal conditioning circuit is an analog reciprocal of the LR series circuit such that the conditioning circuit models a reciprocal impedance of an inductive impedance (L) of the sensing element and a series resistive impedance (R) of the sensing element.

According to one or more additional features, or in the alternative, the sensing element includes a temperature insensitive metal alloy.

According to one or more additional features, or in the alternative, the temperature insensitive metal alloy includes one or a combination of manganin and manganese-based alloy.

According to one or more additional features, or in the alternative, the analog twin circuit device further comprises: a temperature sensor coupled to the sensing element; and a programmable resistor included with the conditioning circuit and in signal communication with the temperature sensor.

According to one or more additional features, or in the alternative, the programmable resistor is configured to vary in response to an output of the temperature sensor.

According to one or more additional features, or in the alternative, varying the programmable resistor changes a frequency characteristic of the signal conditioning circuit.

According to one or more additional features, or in the alternative, the analog twin circuit device further comprises: a first isolator that couples the signal input terminal to the first circuit input terminal; and a second isolator that couples the signal output terminal to the second circuit input terminal.

According to another non-limiting embodiment, a method of sensing an electrical signal comprises delivering the electrical signal to a sensing element, and coupling the sensing element to a conditioning circuit that physically models the sensing element. The method further comprises generating an output signal based on an interaction between the electrical signal and the sensing element and on nonideal parasitics of the sensing element modelled by the conditioning circuit.

According to one or more additional features, or in the alternative, the signal conditioning circuit mimics an impedance of the sensing element.

According to one or more additional features, or in the alternative, the signal conditioning circuit matches the input and output behaviours of the sensing element.

According to one or more additional features, or in the alternative, the sensing element is an inductor-resistor (LR) series circuit.

According to one or more additional features, or in the alternative, the signal conditioning circuit is an analog reciprocal of the LR series circuit such that the conditioning circuit models a reciprocal impedance of an inductive impedance (L) of the sensing element and a series resistive impedance (R) of the sensing element.

According to one or more additional features, or in the alternative, the method comprises: coupling a temperature sensor to the sensing element; delivering an output of the temperature sensor to a programmable resistor included with the conditioning circuit; and varying the programmable resistor in response to changes in the output of temperature sensor.

According to one or more additional features, or in the alternative, the method comprises: changing a frequency characteristic of the signal condition circuiting in response to varying the programmable resistor.

According to one or more additional features, or in the alternative, coupling the coupling the sensing element to the conditioning circuit further comprises: coupling the signal input terminal to the first circuit input terminal via a first isolator; and coupling the signal output terminal to the second circuit input terminal via a second isolator.

According to one or more additional features, or in the alternative, the method comprises: delivering the electrical signal to the sensing element including a temperature insensitive metal alloy to decouple an equivalent-series-inductance (ESL) and an equivalent-series-resistance (ESR) of the sensing circuit so as to reduce power loss of the sensing element.

BRIEF DESCRIPTION OF THE DRAWINGS

FIG. 1 is a block diagram illustrating an analog twin circuit device according to a non-limiting embodiment of the present disclosure;

FIG. 2 is a block diagram illustrating an analog twin circuit device according to a non-limiting embodiment of the present disclosure according to a non-limiting embodiment;

FIG. 3 is a block diagram illustrating an analog twin circuit device including temperature compensation according to a non-limiting embodiment of the present disclosure according to a non-limiting embodiment; and

FIG. 4 is a block diagram illustrating an analog twin circuit device including input and output isolators according to a non-limiting embodiment of the present disclosure according to a non-limiting embodiment.

DETAILED DESCRIPTION

The state-of-art sensing solutions either have limited frequency bandwidth due to the oversimplified sensing principles or the complicated signal processing such as hall-effect sensors, for example, are very expensive due to the sophisticated design implementation such as high bandwidth Rogowski coil sensors. Sensing solutions currently available are also susceptible to reduced accuracy and bandwidth bottleneck due to inevitable parasitics in the sensor when performing sensing in high frequency applications.

Traditional sensors such as current sensors perform sensing and measurement based fully on the purity of the sensing component (e.g., the inductor or resistor). For instance, traditional current sensors do not consider the equivalent-series-resistance (ESR) of the sensing inductor, or the equivalent-series-inductance (ESL) of the current shunt, and assume them having the ideal inductance or ideal resistance. As a result, they only provide a one-dimensional (1D) domain solution, and the sensing capability is limited by the impacts of these existing parasitic resistance and/or the parasitic inductance. The bandwidth of the traditional sensor is also limited by the R/L ratio. A traditional inductor based current sensor (e.g., a di/dt type sensor), for example, expresses voltage as $v=L*di/dt$, and is only able to sense the transient or alternating current (AC) signal whose frequency is much higher than R/L ratio. A small constant direct current (DC) will saturate the conditioning circuit of such sensor. A shunt type sensor expresses voltage as $v=i*R$, and is sufficient for analog current sensing, digital current sensing, or mixed signal sensing, but its sensing bandwidth is also limited by R/L ratio.

Various non-limiting embodiments of the present disclosure provide a high-speed sensing solution based on an analog twin circuit device. The analog twin circuit device includes a sensing element and a signal conditioning circuit. The sensing element is a component that directly interacts with the physical property of matter (e.g., electrical current) to be measured, and provide field information to the conditioning circuit. The conditioning circuit is an analog "twin" circuit, which establishes a similar physical model of the sensing element. Accordingly, the conditioning circuit (i.e., the analog twin circuit) mimics the impedance and/or matches or substantially matches the input and output behaviours of the sensing element. As described herein, "mimics" refers to conditioning circuit providing the same or substantially the same impedance as the sensing element. In this manner, taking the electrical current sensing as an example, the analog twin circuit device models both inductance and resistance including the practical and nonideal parasitics in the sensing element. Therefore, the analog twin circuit device provides a two-dimensional (2D) domain solution, which provides a much wider bandwidth frequency and signal pattern coverage compared to the limited 1D domain solution provided by traditional sensors (e.g., di/dt type sensors) and current shunts.

In low power/voltage/current applications, the sensing element itself can be implemented by low power/-voltage/current components. In high power/voltage/current cases, the sensing element can be implemented as a high-power design and the conditioning circuit (i.e., the analog twin circuit) can be implemented using low power/-voltage/current circuit that provides identical behavior as the sensing element. For example, the conditioning circuit (i.e., the analog twin circuit) can be implemented using traditional R, L, C components, as well as op-amps or other integrated circuit (IC) chips, etc., depending on the specific impedance model of the sensing element.

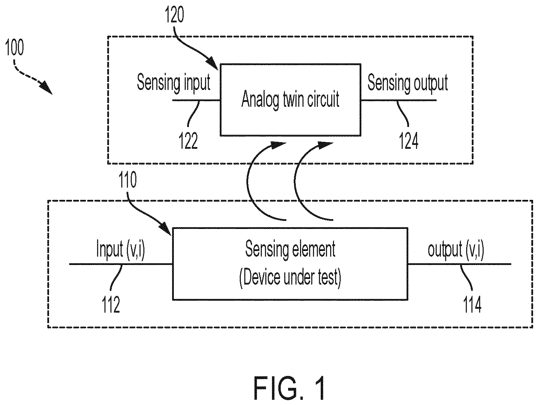

With reference now to FIG. 1, an analog twin circuit device 100 is illustrated according to a non-limiting embodiment of the present disclosure. The analog twin circuit device 100 includes a sensing element 110 and a signal conditioning circuit 120. Although the analog twin circuit device 100 is discussed going forward in terms of an electrical sensing device, it should be appreciated that it may be designed to sense other physical properties of matter such as, for example, fluids, liquids, and gases, and/or other types of forces such as, for example, torque, pressure, etc.

The sensing element 110 includes a signal input terminal 112 and a signal output terminal 114. The signal input terminal 112 directly receives the electrical signal that is to be sensed and delivers the electrical signal to the sensing element 110. The electrical signal can include, for example, voltage and/or current. The sensing element 110 includes one or more electrical components, which interact directly with the electric signal (e.g., the input voltage and/or current signal). Accordingly, the behaviour, characteristics and/or physical properties of the sensing element 110 and/or the electrical signal that appears at the signal output terminal 114 change in response to sensing element's interaction with the input electrical signal. In one or more non-limiting embodiments, the signal output terminal 114 can be connected to a load such as, for example, an actuator, motor, controller, etc. so as to deliver the output electrical signal thereto.

The signal conditioning circuit 120 is an analog "twin" circuit implemented to physically model the sensing element 110. In one or more non-limiting embodiments, the conditioning circuit 120 (i.e., the analog twin circuit) mimics the impedance and/or matches or substantially matches the input and output behaviours of the sensing element 110. In one or more non-limiting embodiments, the conditioning circuit 120 (e.g., analog twin circuit) is implemented as an analog component (resistor, inductor, capacitor, etc.) circuit, which includes one or more circuit input terminals 122 and one or more circuit output terminals 124. The circuit input terminal 122 receives field information to be input to the conditioning circuit. In low-power applications, for example, the circuit input terminal 122 can be connected to the signal input terminal 112 to receive the same electrical voltage signal input to the sensing element. In high-power applications, the circuit input terminal 122 can be isolatively coupled to the signal input terminal. In this manner, a high-power electrical signal present on the signal input terminal 112 can generate a low power electrical signal on the circuit input terminal 122, which in turn is input to the conditioning circuit 120. Accordingly, the conditioning circuit 120 can model the behaviour of the sensing element 110 and mimic the impedance and/or the output appearing at the circuit output terminal 124.

As described herein, the conditioning circuit 120 (e.g., analog twin circuit) utilizes analog electronic components to establish electrical component equivalents that model physical and/or electrical characteristics of the sensing element 110. The electrical component equivalents can include, but are not limited to, inductors (L), resistors (R), capacitors (C), combinations thereof such as RC series circuits, LR series circuits, LRC series circuits, and RC parallel circuits. For example, the electrical equivalent components of the conditioning circuit 120 can be implemented by low profile surface-mount inductor, resistor, capacitor (LRC) elements or together with surface-mount op-amp ICs such as instrumentation amplifiers or differential amplifiers or generic amplifiers, depending on the power and voltage level. Accordingly, different models may be chosen to achieve different performances and different applications. An example of the list is presented below:

- 

$$L: \quad v=L*di/dt \qquad or \quad v= sL*i$$

- 

$$R: \quad v=i*R \qquad or \quad v= i*R$$

-

$$\text{LR:} \quad v=L*di/dt+i*R \quad \text{or} \quad v=(sL+R)*I$$

- 

$$\text{C:} \quad i = C*dv/dt \quad \text{or} \quad i= SC*V$$

- 

$$\text{R+C:} \quad v=1/C*Int(i*dt) + i*R \quad \text{or} \quad V=(1/(SC)+R)*i$$

The conditioning circuit 120 (e.g., analog twin circuit) not only can be implemented as a direct miniature duplication of the sensing element 110, but also can be implemented as a reciprocal miniature duplication of the sensing element 110. As used herein, the term "duplication" refers to a similar physical property from one or more aspects of the sensing element 110.

According to a non-limiting embodiment, the sensing element 110 can be implemented as a shunt resistor and the conditioning circuit 120 (e.g., analog twin circuit) can be constructed as the mirror conductance (G) of the shunt resistor 110 to establish a model of the conductance (with a scaling ratio in place) through the sensing element 110 as, $G = i/v$, where "G" is conductance, "i" is current flowing through the element, and "v" is voltage applying on the element. Accordingly, the current flowing through the sensing element 110 (e.g., shunt resistor) can be sensed at the circuit output terminal 124 of the conditioning circuit 120.

According to a non-limiting embodiment, the sensing element 110 can be implemented as an inductor and the conditioning circuit 120 (e.g., analog twin circuit) can be constructed as a mirror admittance (Y) of the inductor 110 to establish a model of the admittance through the sensing element 110 as $Y= i/v$, where "i" is the output current and "v" is the input voltage (e.g., appearing at the signal input terminal 112). Accordingly, the current flowing through the sensing element 110 (e.g., the inductor) can be sensed at the circuit output terminal 124 of the conditioning circuit 120.

In the example described above, the conditioning circuit 120 (e.g., analog twin circuit) can also be constructed as a mirror inductance of the inductor used to implement the sensing element. For instance, the mirror inductance of the inductor can be established using a resistor divider, an impedance mismatching follower, and then a signal level inductor. In this manner, the analog twin circuit device 100 is able to be used as a high-speed current sensor at low input power signal levels or high-speed sensing at high input power signal levels.

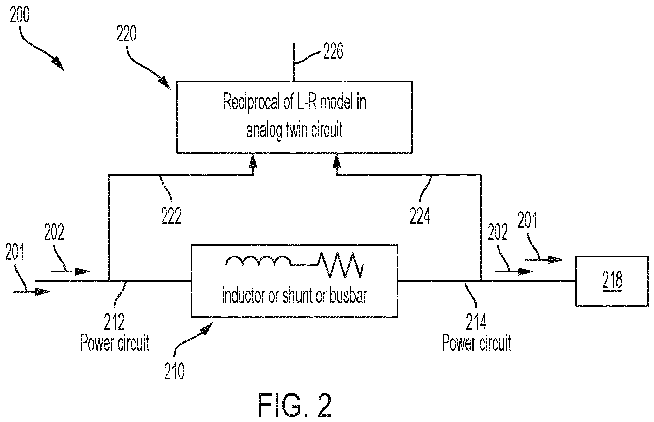

Turning to FIG. 2, an analog twin circuit device 200 is illustrated according to a non-limiting embodiment of the present disclosure. In this example, the analog twin circuit device 200 is configured to sense current, but it should be appreciated that the analog twin circuit device 200 can perform different types of sensing such as voltage, for example, without departing from the scope of the invention.

The analog twin circuit device 200 includes a sensing element 210 and a signal conditioning circuit 220. The sensing element 210 includes a signal input terminal 212 and a signal output terminal 214. The signal input terminal 212 directly receives the electrical signal (e.g., voltage signal 201 and/or current signal 202) that is to be sensed. The sensing element 210 includes one or more electrical components including, but not limited to, an inductor, a shunt (e.g., a shunt resistor, a shunt capacitor, etc.), a busbar, or a combination thereof. Accordingly, the sensing element 210 interacts directly with the electrical signal (e.g., voltage and current) input to the signal input terminal 212, and delivers its output, e.g., output current 202 to the signal output terminal 214. In one or more non-limiting embodiments, the signal output terminal 214 can be connected to a load 218 such as, for example, such as, for example, an actuator, motor, controller, etc.

In one or more non-limiting embodiments, the component(s) used for the sensing element 210 are formed from a temperature insensitive metal alloy that has zero, or substantially zero, temperature coefficient of resistance. In one or more non-limiting embodiments, the temperature insensitive metal alloy includes, but is not limited to, manganin, a manganese-based alloy, or a combination thereof. In one or more non-limiting embodiments, a hybrid construction of the sensing element 210 can be implemented where the dominant equivalent series inductor (ESL) is formed from copper and the dominant equivalent series resistor (ESR) is formed from the temperature insensitive metal alloy (e.g., manganin). In this manner, the ESL and ESR can be approximately decoupled and the overall resistance in-circuit and its resulting conduction power loss caused by temperature effects are also be minimized. In another example where the sensing element 210 is implemented as a current shunt, the sensing resistance element is formed from the temperature insensitive metal alloy (e.g., manganin) while the input and output terminals 212 and 214 are formed from copper. Accordingly, the analog twin circuit device 200 using a shunt sensing element 210 can resolve both the ESL negative sensing bandwidth issue and temperature induced ESR issues.

The signal conditioning circuit 220 (i.e., the analog "twin" circuit) physically models the sensing element 220. In one or more non-limiting embodiments, the conditioning circuit 220 mimics the impedance and/or matches or substantially matches the input and output behaviours of the sensing element 210. In one or more non-limiting embodiments, the conditioning circuit 220 is implemented as an analog reciprocal of the inductor-resistor (LR) series circuit that physically models the electrical components (e.g., used to establish the sensing element 210). That is, the conditioning circuit 220 models the reciprocal impedance of the inductive impedance (L) of the sensing element 210 and the series resistive impedance (R) of the sensing element 210.

The signal conditioning circuit 220 includes two circuit input terminals 222 and 224, and a circuit output terminal 226. The first circuit input terminal 222 is connected directly to the signal input terminal 212, and the second circuit input terminal 224 is connected directly to the signal output terminal 214. Accordingly, the electrical voltage signals 201 of the terminal 212 and terminal 214 are commonly shared by both the sensing element 210 and the signal conditioning circuit 220. Accordingly, the signal conditioning circuit 220, which physically models the sensing element 220, interacts with the input and output voltage 201 signals of the terminal 212 and terminal 214, and the input electrical current 202 which is the same as the output current 202202 can then be sensed via the circuit output terminal 226. Compared to a traditional current sensor or current shunt, the analog twin circuit device 200 described herein does not put the stake fully on the purity of L or R. Instead, the analog twin circuit device 200 takes account of the practical and nonideal parasitics in the sensing element. For instance, the analog twin circuit device 200 considers the equivalent-series-resistance (ESR) of the sensing inductor, or the equivalent-series-inductance (ESL) of the shunt, or the ESL and ESR of the busbar. That is, the analog twin circuit device 200 models both L and R, and hence provides a two-dimensional (2D) domain solution, showing much wider bandwidth frequency and signal pattern coverage, compared to the one-dimensional (1D) domain solution provided by traditional sensors.

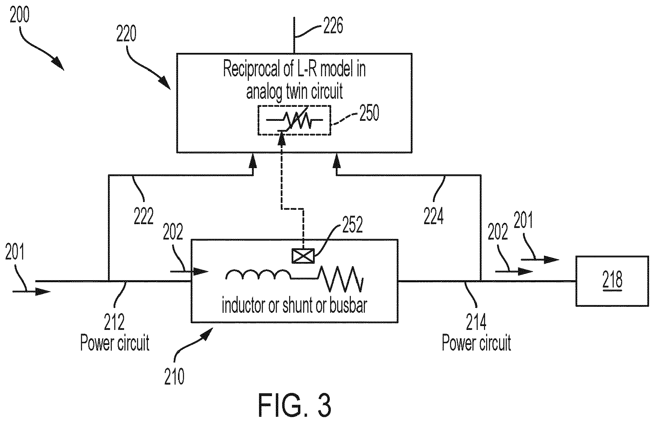

Referring to FIG. 3, the analog twin circuit device 200 is illustrated according to a non-limiting embodiment of the present disclosure. The analog twin circuit device 200 operates in the manner described in detail, but also provides an active compensation of the sensing gain through temperature sensing feedback. According to a non-limiting embodiment, the sensing element 210 includes a temperature sensor 252, while the conditioning circuit 220 that implements the reciprocal of L-R model includes a programmable resistor 250 (details not shown) that can be varied to change the frequency characteristic of the L-R model. The temperature sensor 252 (e.g., a surface mount temperature sensor) is coupled to the sensing element 210 and includes an output in signal communication with the variable resistor. Accordingly, as the temperature signal output from the temperature sensor 252 changes, the variable resistor is varied. In this manner, the input-output frequency characteristic of the analog twin circuit device 200 can be dynamically tuned or adjusted to compensate for the temperature effect suffered by the ESR of the sensing element 210 when it is operated in varying power load or varying temperature conditions and improve the sensing accuracy of the analog twin circuit device 200.

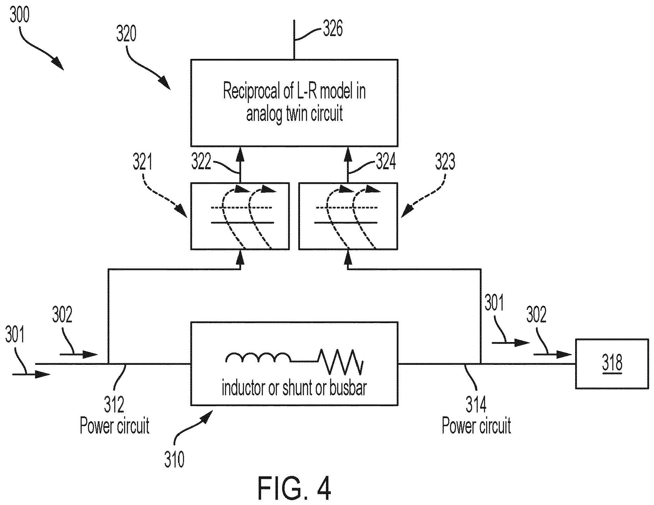

Turning to FIG. 4, an analog twin circuit device 300 is illustrated according to another non-limiting embodiment of the present disclosure. The analog twin circuit device 300 is configured to sense current, but it should be appreciated that the analog twin circuit device 300 can perform different types of sensing such as voltage, for example, without departing from the scope of the invention.

The analog twin circuit device 300 includes a sensing element 310 and a signal conditioning circuit 320. The sensing element 310 includes a signal input terminal 312 and a signal output terminal 314. The signal input terminal 312 directly receives the electrical current 302 that is to be sensed. The sensing element 310 includes one or more electrical components including, but not limited to, an inductor, a shunt (e.g., a shunt resistor, a shunt capacitor, etc.), a busbar, or a combination thereof. Accordingly, the sensing element 310 interacts directly with the electrical current input to the signal input terminal 312, and delivers its output, e.g., output current 302 to the to the signal output terminal 314. Through this, the sensing element 310 produces a voltage difference between its input terminal 312 and output terminal 314 which will be used by sensing conditioning circuit 320. In one or more non-limiting embodiments, the signal output terminal 314 can be connected to a load 318 such as, for example, such as, for example, an actuator, motor, controller, etc.

As described herein, the component(s) used for the sensing element 310 are formed from a temperature insensitive metal alloy that has zero, or substantially zero, temperature coefficient of resistance. In one or more non-limiting embodiments, the temperature insensitive metal alloy includes, but is not limited to, manganin, a manganese-based alloy, or a combination thereof. In applications where the sensing element 310 implements a busbar or inductor, a hybrid construction of the sensing element 310 can be employed where the dominant equivalent series inductor (ESL) is formed from copper and the dominant equivalent series resistor (ESR) is formed from the temperature insensitive metal alloy (e.g., manganin). In this manner, the ESL and ESR can be approximately decoupled and the overall resistance in-circuit and its resulting conduction power loss caused by temperature effects are also be minimized, which is desirable in high current applications. In another example where the sensing element 310 is implemented as a current shunt, the sensing resistance element is formed from the temperature insensitive metal alloy (e.g., manganin) while the input and output terminals 312 and 314 are formed from copper.

The signal conditioning circuit 320 (i.e., the analog "twin" circuit) physically models the sensing element 320. In one or more non-limiting embodiments, the conditioning circuit 320 mimics the impedance or the reciprocal impedance and/or matches, or substantially matches, the input and output behaviours of the sensing element 310. In one or more non-limiting embodiments, the conditioning circuit 320 is implemented as an analog inductor-resistor (LR) series circuit or the reciprocal of L-R circuit that physically models the electrical components (e.g., used to establish the sensing element 310).

The signal conditioning circuit 320 includes a circuit input terminal 322, another circuit input terminal 324, and a circuit output terminal 326. The circuit input terminal 322 is electrically coupled to the signal input terminal 312 via a first isolator 321, and the circuit input terminal 324 is electrically coupled to the signal output terminal 314 via a second isolator 323. Various isolator devices can be utilized to implement the isolators including, but not limited to, a high impedance resistor divider, and cascaded combination of a resistor divider with capacitive isolator, opto-coupler, or silicon dioxide (SiO2) isolator. The first and second isolators 321 and 323 electrically isolate the signal conditioning circuit 320 from high power (e.g., high voltage) appearing on the signal input terminal 312 and the signal output terminal 314, respectively. In this manner, the analog twin circuit device 300 can be used in high-power high voltage applications without being damaged.

The electrical voltage 301 and/or current 302 to be sensed is input to the signal input terminal 312 and is delivered to the sensing element 310. The output current 302 which is the same as the input current can be delivered to the signal output terminal 314 and to an electrical load 318. The first isolator 321 and the second isolator 323 can step down the high voltage potentials and electrically isolate them, while also passing the input and output voltage of the sensing element 310 at a negligible current level to the circuit input terminal 322 and 324, respectively. Accordingly, the signal conditioning circuit 320 responses to the sensed voltage across the sensing element 310 and generates the current sensing signal 308 either in voltage signal format or in current signal format depending on the circuit implementation via the circuit output terminal 326. In one or more non-limiting embodiments a scaling ratio can be applied to the sensed current 302 to take into account all the gain ratios through the voltage isolator and the conditioning circuit 320.

As described herein, an analog twin circuit device is provided, which includes a conditioning circuit employed as an analog "twin" circuit, which establishes a similar physical model of the sensing element to mimic its impedance and/or match its input and output behaviours. In this manner, the analog twin circuit device models both inductance and resistance including the practical and nonideal parasitics in the sensing element. Therefore, the analog twin circuit device provides a two-dimensional (2D) domain solution, which provides a much wider bandwidth frequency and signal pattern coverage compared to the limited 1D domain solution provided by traditional sensors (e.g., di/dt type sensors) and current shunts.

## Claims

1. An analog twin circuit device comprising:

   a sensing element (110, 210, 310) including a signal input terminal configured to receive an input signal and a signal output terminal configured to output a signal; and
   a signal conditioning circuit (120, 220 320) including a first circuit input terminal connected to the signal input terminal and a second circuit input terminal connected to the signal output terminal such that the sensing element (110, 210 310) is configured to interact directly with the input signal and delivers an output signal to the signal output terminal,
   wherein the signal conditioning circuit (120, 220 320) physically models the sensing element (110, 210 310).

2. The analog twin circuit device of claim 1, wherein the signal conditioning circuit (120, 220 320) is configured to mimic an impedance of the sensing element (110, 210 310).

3. The analog twin circuit device of claim 2, wherein the signal conditioning circuit (120, 220 320) is configured to match an input behaviour and output behaviour of the sensing element (110, 210 310).

4. The analog twin circuit device of claim 3, wherein the sensing element (110, 210 310) is an inductor-resistor (LR) series circuit, and optionally wherein the signal conditioning circuit (120, 220 320) is an analog reciprocal of the LR series circuit such that the conditioning circuit models a reciprocal impedance of an inductive impedance (L) of the sensing element (110, 210 310) and a series resistive impedance (R) of the sensing element (110, 210 310).

5. The analog twin circuit of any preceding claim, wherein the sensing element (110, 210 310) includes a temperature insensitive metal alloy, and optionally wherein the temperature insensitive metal alloy includes one or a combination of manganin and manganese-based alloy.

6. The analog twin circuit of any preceding claim, further comprising:

   a temperature sensor coupled to the sensing element (110, 210 310); and
   a programmable resistor included with the conditioning circuit and in signal communication with the temperature sensor.

7. The analog twin circuit of claim 6, wherein the programmable resistor is configured to vary in response to an output of the temperature sensor, and optionally wherein varying the programmable resistor is configured to change a frequency characteristic of the signal conditioning circuit (120, 220 320).

8. The analog twin circuit of any preceding claim, further comprising:

   a first isolator that couples the signal input terminal to the first circuit input terminal; and
   a second isolator that couples the signal output terminal to the second circuit input terminal.

9. A method of sensing an electrical signal, the method comprising:

   delivering the electrical signal to a sensing element (110, 210 310);
   coupling the sensing element (110, 210 310) to a conditioning circuit configured to physically model the sensing element (110, 210 310); and
   generating an output signal based on an interaction between the electrical signal and the sensing element (110, 210 310) and on nonideal parasitics of the sensing element (110, 210 310) modelled by the conditioning circuit.

10. The method of claim 9, wherein the signal conditioning circuit (120, 220 320) is configured to mimic an impedance of the sensing element (110, 210 310).

11. The method of claim 10, wherein the signal conditioning circuit (120, 220 320) is configured to match an input behaviour and output behaviour of the sensing element (110, 210 310).

12. The method of claim 11, wherein the sensing element (110, 210 310) is an inductor-resistor (LR) series circuit, and optionally wherein the signal conditioning circuit (120, 220 320) is an analog reciprocal of the LR series circuit such that the conditioning circuit models a reciprocal impedance of an inductive impedance (L) of the sensing element (110, 210 310) and a series resistive impedance (R) of the sensing element (110, 210 310).

13. The method of any of claims 9 to 12, further comprising:

   coupling a temperature sensor to the sensing element (110, 210 310);
   delivering an output of the temperature sensor to a programmable resistor included with the conditioning circuit; and
   varying the programmable resistor in response to changes in the output of temperature sensor, and optionally further comprising changing a frequency characteristic of the signal condition circuiting in response to varying the programmable resistor.

14. The method of any of claims 9 to 13, wherein coupling the coupling the sensing element (110, 210 310) to the conditioning circuit further comprises :

   coupling the signal input terminal to the first circuit input terminal via a first isolator; and
   coupling the signal output terminal to the second circuit input terminal via a second isolator.

15. The method of any of claims 9 to 14, further comprising delivering the electrical signal to the sensing element (110, 210 310) including a temperature insensitive metal alloy to decouple an equivalent-series-inductance (ESL) and an equivalent-series-resistance (ESR) of the sensing circuit so as to reduce power loss of the sensing element (110, 210 310).

120

100

Sensing input      Sensing output

Analog twin circuit

122      124

110

Input (v,i)      output (v,i)

Sensing element
(Device under test)

112      114

FIG. 1

FIG. 2

FIG. 3

FIG. 4

Europäisches
Patentamt

European
Patent Office

Office européen
des brevets

# EUROPEAN SEARCH REPORT

Application Number

EP 24 17 0318

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2021/048453 A1 (CHAO HIO LEONG [US]) 18 February 2021 (2021-02-18) | 1-3,9-11 | INV. G01R19/00 G01D3/036 G01R1/20 |
| Y | * paragraph [0015] - paragraph [0033]; | 5 | |
| A | figures 1, 7 * | 4,6-8, 12-15 | |
| | ----- | | |
| Y | US 11 105 835 B2 (CONTINENTAL AUTOMOTIVE GMBH [DE]) 31 August 2021 (2021-08-31) | 5 | |
| A | * column 6; figures 1-2 * | 1-4,6-15 | |
| | ----- | | |
| A | US 2011/109302 A1 (PERETTO LORENZO [IT] ET AL) 12 May 2011 (2011-05-12) * the whole document * | 1-15 | |
| | ----- | | |
| A | LOSSOUARN BORIS ET AL: "An analogue twin for piezoelectric vibration damping of multiple nonlinear resonances", JOURNAL OF SOUND AND VIBRATION, ELSEVIER, AMSTERDAM , NL, vol. 511, 29 June 2021 (2021-06-29), XP086931631, ISSN: 0022-460X, DOI: 10.1016/J.JSV.2021.116323 [retrieved on 2021-06-29] * the whole document * | 1-15 | TECHNICAL FIELDS SEARCHED (IPC) G01D G01R H02M H01C H01L G01K |
| | ----- | | |
| A | US 6 433 386 B1 (YUN CHONG-MAN [KR] ET AL) 13 August 2002 (2002-08-13) * the whole document * | 1-15 | |
| | ----- | | |
| A | US 2022/399884 A1 (KAYA CETIN [US] ET AL) 15 December 2022 (2022-12-15) * the whole document * | 1-15 | |
| | ----- | | |

The present search report has been drawn up for all claims

| Place of search | Date of completion of the search | Examiner |
|---|---|---|
| Munich | 8 November 2024 | Ako, Thomas |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

.............................................................................

& : member of the same patent family, corresponding document

EPO FORM 1503 03.82 (P04C01)

## ANNEX TO THE EUROPEAN SEARCH REPORT
## ON EUROPEAN PATENT APPLICATION NO.

EP 24 17 0318

This annex lists the patent family members relating to the patent documents cited in the above-mentioned European search report.
The members are as contained in the European Patent Office EDP file on
The European Patent Office is in no way liable for these particulars which are merely given for the purpose of information.

08-11-2024

| Patent document cited in search report | Publication date | Patent family member(s) | Publication date |
|---|---|---|---|
| US 2021048453 A1 | 18-02-2021 | NONE | |
| US 11105835 B2 | 31-08-2021 | CN 111044768 A | 21-04-2020 |
| | | EP 3640651 A1 | 22-04-2020 |
| | | US 2020116764 A1 | 16-04-2020 |
| US 2011109302 A1 | 12-05-2011 | CA 2729982 A1 | 21-01-2010 |
| | | EP 2356473 A1 | 17-08-2011 |
| | | IT 1391344 B1 | 05-12-2011 |
| | | RU 2011105193 A | 20-08-2012 |
| | | US 2011109302 A1 | 12-05-2011 |
| | | WO 2010007017 A1 | 21-01-2010 |
| US 6433386 B1 | 13-08-2002 | DE 19823140 A1 | 29-04-1999 |
| | | FR 2769988 A1 | 23-04-1999 |
| | | KR 19990032990 A | 15-05-1999 |
| | | US 6433386 B1 | 13-08-2002 |
| US 2022399884 A1 | 15-12-2022 | US 2022399884 A1 | 15-12-2022 |
| | | US 2024275374 A1 | 15-08-2024 |

EPO FORM P0459

For more details about this annex : see Official Journal of the European Patent Office, No. 12/82